# EUROPÄISCHE PATENTSCHRIFT

(11) **EP 3 738 211 B1**
(45) Veröffentlichungstag und Bekanntmachung des Hinweises auf die Patenterteilung: **06.12.2023**
(21) Anmeldenummer: 19700205.8
(22) Anmeldetag: 04.01.2019
(51) Int. Cl.: G01D 5/24, G05G 9/047

(54) **VERFAHREN ZUR BESTIMMUNG DER AUSLENKUNG DES BETÄTIGUNGSGLIEDS EINES KAPAZITIVEN MEHRWEGE-KRAFTSENSORBAUSTEINS**
METHOD FOR DETERMINING THE DEFLECTION OF THE ACTUATOR OF A CAPACITIVE MULTIPATH FORCE SENSOR MODULE
PROCÉDÉ POUR DÉTERMINER LA DÉVIATION DE L'ÉLÉMENT D'ACTIONNEMENT D'UN COMPOSANT CAPTEUR DE FORCE CAPACITIF À PLUSIEURS VOIES

(30) Priorität: 08.01.2018 DE 102018000078
(43) Veröffentlichungstag der Anmeldung: 18.11.2020
(73) Patentinhaber: KOSTAL Automobil Elektrik GmbH & Co. KG, 58513 Lüdenscheid (DE)
(72) Erfinder: LUX, Marc, 44791 Bochum (DE); SEIFERT, Matthias, 44789 Bochum (DE)
(74) Vertreter: Kerkmann, Detlef
(86) Internationale Anmeldenummer: PCT/EP2019/050178
(87) Internationale Veröffentlichungsnummer: WO 2019/134977

(56) Entgegenhaltungen:
- WO-A1-2016/016612
- DE-A1-102014 014 021
- US-A1- 2011 001 549

## Beschreibung

Die Erfindung betrifft ein Verfahren zur Bestimmung der Auslenkung des Betätigungsglieds eines kapazitiven Mehrwege-Kraftsensorbausteins mit einem aus seiner Neutralstellung in zumindest zwei Betätigungsrichtungen verstellbaren Betätigungsglied, das sich bei Fortfall einer Betätigungskraft wieder in seine Neutralstellung zurückverlagert, und mit dem eine zentrale Kondensatorplatte verbunden ist, die sich in der Ruhelage des Betätigungsglieds im Abstand zu zumindest einer ersten und einer zweiten ortsfesten Kondensatorplatte befindet, und durch Verstellung des Betätigungsglieds zumindest eine erste ortsfeste Kondensatorplatte zu und von zumindest einer zweiten weg verlagert wird, und wobei zur Erzeugung eines die Auslenkung des Betätigungsglieds repräsentierenden Sensorwertes zumindest ein durch die zentrale Kondensatorplatte mit zumindest einer ersten ortsfesten Kondensatorplatte gebildeter Messkondensator verwendet wird.

Mehrwege-Kraftsensorbausteine der hier angesprochenen Art werden etwa in Kraftfahrzeugen als universell verwendbare Komponenten zum Aufbau von mehr oder weniger komplexen Schalteranordnungen verwendet.

Die Kraftsensorbausteine sind dabei vorzugsweise etwa als Zweiwege- oder Vierwege-Kraftsensorbausteine ausgebildet und auf einer gemeinsamen Leiterplatte montiert, die in einem eine Bedienoberfläche mit den Kraftsensorbausteinen zugeordneten Betätigungsgriffstücken aufweisenden Gehäuse aufgenommen ist.

Mehrwege-Kraftsensorbausteine, die in derartigen Schalteranordnungen eingesetzt werden, verwenden zur Messung einer Kraft in einer oder zwei Achsen paarweise gegenüberliegend angeordnete kapazitive Sensoren. Diese Sensoren werden gebildet durch jeweils eine ortsfeste Kondensatorplatte und eine dieser jeweils zugeordnete und mittels eines Betätigungsglieds auslenkbare Kondensatorplatte. Abhängig vom Abstand der auslenkbaren Kondensatorplatte zu jeder der ortsfesten Kondensatorplatten ergeben sich spezifische kapazitive Messwerte, anhand derer auf die Auslenkung, und über die dem mechanischen Aufbau zugrunde liegende Kraft-Weg-Kennlinie indirekt auf die auf das Betätigungsglied ausgeübte Kraft zurückgeschlossen werden kann. Da die jeweiligen Kapazitätswerte umgekehrt proportional zum Abstand der jeweiligen Kondensatorplatten sind, ergibt sich bezüglich der gegenüberliegend angeordneten Kondensatoren, die sich eine gemeinsame zentrale Kondensatorplatte "teilen", eine Symmetrie ihrer Kennlinien, also der Abhängigkeit des Messwerts von der jeweiligen Auslenkung des Betätigungsglieds. Bei positiver und negativer Auslenkung, bezogen jeweils auf eine Achse, des Betätigungsglieds und der mit diesem verbundenen Kondensatorplatte ist daher immer ein im Wesentlichen "gleicher" Teil der Kennlinie, einmal bezogen auf die eine und einmal bezogen auf die andere ortsfeste Kondensatorplatte, relevant.

Die Offenlegungsschrift US 2011/0001549 A1 offenbart ein Bestimmungsverfahren eines Kapazitätswerts mittels eines Integrationskondensators. Dabei wird eine Bezugs-Elektrode auf einem Massepotential gehalten, während eine Sensorelektrode sowie eine Schirmungselektrode jeweils mit einem von dem Massepotential verschiedenen Spannungspotential verbunden werden.

Die deutsche Offenlegungsschrift DE 10 2014 014 021 A1 offenbart einen kapazitiven Vierwege-Kraftsensorbaustein zur Durchführung eines Verfahrens gemäß dem Oberbegriff des Patentanspruchs 1.

Das Verfahren zum Betreiben eines kapazitiven Mehrwege-Kraftsensorbausteins gemäß der vorliegenden Erfindung stellt eine besonders kostengünstige und zuverlässige Möglichkeit zur Bestimmung der gesuchten, die jeweilige Auslenkung des Betätigungsglieds repräsentierenden Sensorwerte zur Verfügung.

Dies wird erfindungsgemäß dadurch erreicht, dass die erste ortsfeste Kondensatorplatte auf einem Massepotential gehalten wird, dass in einem fortlaufend angewendeten Integrationsverfahren in mehreren aufeinander folgenden Zyklen jeweils:
- die zentrale Kondensatorplatte sowie zumindest die zweite ortsfeste Kondensatorplatte mit einem von dem Massepotential verschiedenen Spannungspotential verbunden und dann von diesem wieder getrennt werden,
- eine auf der zentralen Kondensatorplatte gespeicherte Ladungsmenge auf einen Integrationskondensator mit einem bekannten Kapazitätswert übertragen wird,

dass nach einer vorgegebenen Anzahl von Zyklen die dann an dem Integrationskondensator anliegende Spannung mittels eines A/D-Wandlers gemessen und zu dem ersten Sensorwert verarbeitet wird,
und dass zur Erzeugung eines zweiten, die Auslenkung des Betätigungsglieds repräsentierenden Sensorwertes ein durch die zentrale Kondensatorplatte mit der zweiten ortsfesten Kondensatorplatte gebildeter Messkondensator verwendet wird.

Gerade in solchen Anwendungen, in denen nur sehr kleine Auslenkungen des Betätigungshebels erwünscht oder zulässig sind, und die als wesentliches Kriterium für die Auslösung eines Schaltsignals das Erreichen einer bestimmten Betätigungskraft vorsehen, kann der erfindungsgemäße elektrische Mehrwege-Schalterbaustein als quasi kraftsensitiver Schalterbaustein vorteilhaft eingesetzt werden.

In einer bevorzugten Ausführungsform des erfindungsgemäßen Verfahrens befindet sich die zentrale Kondensatorplatte in der Ruhelage des Betätigungsglieds in einem im Wesentlichen gleichen Abstand zu der ersten und der zweiten ortsfesten Kondensatorplatte und wird durch Verstellung des Betätigungsglieds im gleichen Maße auf die erste ortsfeste Kondensatorplatte zu und von der zweiten ortsfesten Kondensatorplatte weg verlagert.

Nachfolgend ist die Erfindung unter Bezugnahme auf die beigefügte Zeichnung erläutert.

Dabei zeigen:
- **Fig. 1:**: eine schematische Darstellung eines zur Anwendung des erfindungsgemäßen Verfahrens vorgesehenen kapazitiven Mehrwege-Kraftsensorbausteins mit einem in zwei Richtungen entlang einer Achse verstellbaren Betätigungsglied
- **Fig. 2:**: eine schematische Darstellung eines zur Anwendung des erfindungsgemäßen Verfahrens vorgesehenen kapazitiven Mehrwege-Kraftsensorbausteins mit einem um zwei zueinander senkrechte Achsen verschwenkbar angeordneten Betätigungsglied

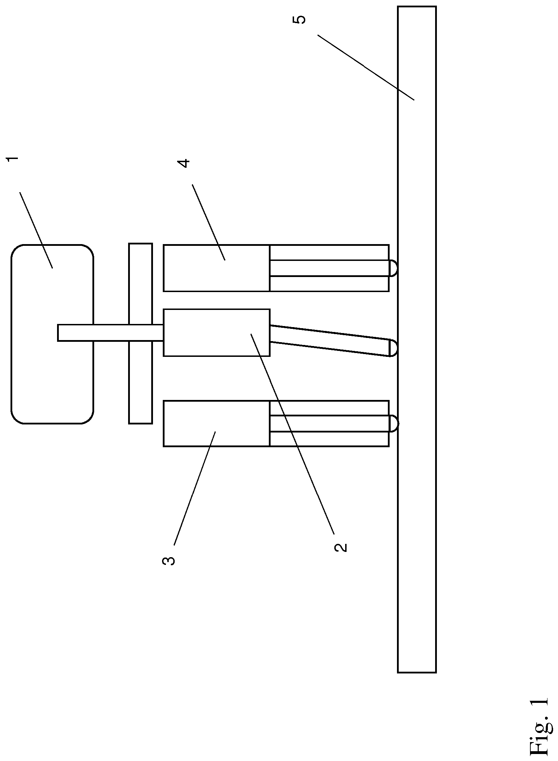

Bei dem in Fig. 1 gezeigten Beispiel ist das Betätigungsglied 1 in zwei Richtungen entlang einer Achse verstellbar. Zwei äußere ortsfeste Kondensatorplatten 3, 4 sind mit Leiterbahnen einer elektrischen Leiterplatte 5 elektrisch verbunden und mit ihren Hauptflächen senkrecht zu dieser Leiterplatte angeordnet. Zwischen diesen beiden ortsfesten Kondensatorplatten 3, 4 befindet sich eine zentrale Kondensatorplatte 2, die mit einem Betätigungsglied 1 in zwei Richtungen entlang einer Achse parallel zu der Leiterplatte 5 und senkrecht zu den Hauptflächen der Kondensatorplatten 2, 3, 4 verstellbar und ebenfalls mit Leiterbahnen der elektrischen Leiterplatte 5 elektrisch verbunden ist.

Die mit dem Betätigungsglied 1 verbundene zentrale Kondensatorplatte 2 befindet sich in der Ruhelage desselben im gleichen Abstand zu zwei äußeren ortsfesten Kondensatorplatten 3, 4. Eine Verstellung des Betätigungsglieds 1 aus dieser Ruhelage in eine Richtung bewirkt, dass die zentrale Kondensatorplatte 2 im gleichen Maße auf die eine der beiden äußeren ortsfesten Kondensatorplatten 4 zu und von der anderen ortsfesten Kondensatorplatte 3 weg verlagert wird. Die zentrale Kondensatorplatte 2 bildet dabei mit den beiden äußeren Kondensatorplatten 3, 4 jeweils Messkondensatoren, deren Kapazitätswerte zur Erzeugung zweier unterschiedlicher, die Auslenkung des Betätigungsglieds repräsentierender Sensorwerte verwendet werden.

Dabei erfolgt die Anwendung des erfindungsgemäßen Verfahrens indem zunächst eine erste der beiden ortsfesten Kondensatorplatten 3 auf einem Massepotential gehalten wird. Die mit dem Betätigungsglied 1 verbundene zentrale Kondensatorplatte 2 und die zweite ortsfeste Kondensatorplatte 4 werden dann mit einem von dem Massepotential verschiedenen Spannungspotential verbunden und anschließend von diesem wieder getrennt, und danach eine auf der zentralen Kondensatorplatte 2 gespeicherte Ladungsmenge auf einen Integrationskondensator mit einem bekannten Kapazitätswert übertragen. Diese Schritte werden im Rahmen eines fortlaufend angewendeten Integrationsverfahrens in mehreren aufeinander folgenden Zyklen ausgeführt, und nach einer vorgegebenen Anzahl von Zyklen wird die dann an dem Integrationskondensator anliegende Spannung mittels eines A/D-Wandlers gemessen und zu einem ersten die Auslenkung des Betätigungsglieds repräsentierenden Sensorwert verarbeitet.

Sofort anschließend wird das gleiche Verfahren erneut durchgeführt, wobei jedoch die Rollen der beiden ortsfesten Kondensatorplatten 3, 4 vertauscht werden, d.h. diejenige ortsfeste Kondensatorplatte 3, die zuvor auf dem Massepotential gehalten wurde, wird nun mit dem von dem Massepotential verschiedenen, mit dem der zentralen Kondensatorplatte identischen Spannungspotential verbunden und umgekehrt. Nach Durchführung der Schritte des gerade beschriebenen Integrationsverfahrens wird auch hier nach der vorgegebenen Anzahl von Zyklen die dann an dem Integrationskondensator anliegende Spannung mittels eines A/D-Wandlers gemessen und zu einem zweiten die gleiche Auslenkung des Betätigungsglieds repräsentierenden Sensorwert verarbeitet.

Die auf diese Weise ermittelten ersten und zweiten Sensorwerte repräsentieren die gleiche Auslenkung des Betätigungsglieds 1 mit jeweils entgegengesetzten Vorzeichen, so dass hiermit praktisch eine redundante Erfassung dieser Auslenkung realisiert ist, was zur Erhöhung der Zuverlässigkeit genutzt werden kann.

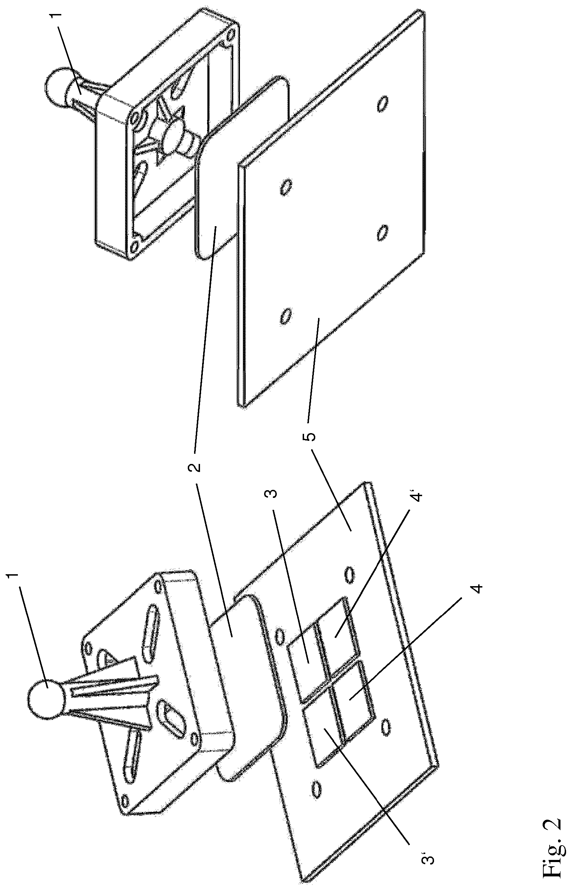

Bei dem in Fig. 2 gezeigten Beispiel ist das Betätigungsglied 1 um zwei zueinander senkrechte Achsen verschwenkbar angeordnet. Die mit dem Betätigungsglied 1 verbundene zentrale Kondensatorplatte 2 befindet sich in der Ruhelage des Betätigungsglieds 1 im gleichen Abstand zu vier dieser gegenüberliegend auf einer Leiterplatte 5 angeordneten ortsfesten Kondensatorplatten 3, 3', 4, 4'. Dabei bilden zwei dieser ortsfesten Kondensatorplatten 3, 3', 4, 4' ein erstes Paar 3, 4, das einer Verschwenkung des Betätigungsglieds 1 um eine erste Achse zugeordnet ist, die beiden anderen bilden ein zweites Paar 3', 4', das einer Verschwenkung des Betätigungsglieds 1 um die dazu senkrechte zweite Achse zugeordnet ist.

Eine Versschwenkung des Betätigungsglieds 1 aus der Ruhelage um die erste Achse bewirkt, dass die zentrale Kondensatorplatte 2 im gleichen Maße auf die eine der beiden, dieser Verschwenkung zugeordneten Kondensatorplatten 4 zu und von der anderen Kondensatorplatte 3 weg verlagert wird.

Die zentrale Kondensatorplatte 2 bildet dabei mit diesen beiden ortsfesten Kondensatorplatten 3,4 jeweils Messkondensatoren, deren Kapazitätswerte zur Erzeugung eines die Auslenkung des Betätigungsglieds 1 repräsentierenden Sensorwertes verwendet werden. Bezüglich der beiden anderen, der Verschwenkung um die zweite Achse zugeordneten ortsfesten Kondensatorplatten 3', 4' bewirkt die Verschwenkung des Betätigungsglieds 1 um die erste Achse praktisch keine Veränderung.

Die Anwendung des erfindungsgemäßen Verfahrens erfolgt hier, wie schon zuvor bezüglich der einachsigen Ausführung in Fig. 1 beschrieben, indem zunächst eine erste der beiden der Verschwenkung um die erste Achse zugeordneten ortsfesten Kondensatorplatten 3 auf einem Massepotential gehalten wird. Die mit dem Betätigungsglied verbundene zentrale Kondensatorplatte 2 und in diesem Fall alle drei übrigen ortsfesten Kondensatorplatten 3', 4, 4' werden dann mit einem von dem Massepotential verschiedenen Spannungspotential verbunden und anschließend von diesem wieder getrennt, und danach eine auf der zentralen Kondensatorplatte 2 gespeicherte Ladungsmenge auf einen Integrationskondensator mit einem bekannten Kapazitätswert übertragen.

Die weiteren Schritte des Verfahrens werden mutatis mutandis, wie zuvor bereits bezüglich der einachsigen Ausführung beschrieben, ausgeführt.

Bei dieser Art von Messung wird immer genau eine ortsfeste Kondensatorplatte auf Massepotential gehalten und die übrigen ortsfesten Kondensatorplatten als aktive Schirmung betrieben, indem diese mit dem gleichen Potential wie die bewegbare zentrale Kondensatorplatte 2 beaufschlagt werden. Die als Schirmung beschalteten Kondensatorflächen sind auf Grund der Potentialgleichheit mit der zentralen Kondensatorplatte 2 für die beschriebene kapazitive Messung praktisch "unsichtbar" und tragen somit nicht signifikant zu der kapazitiven Abstandsmessung bei.

## Patentansprüche

1. Verfahren zur Bestimmung der Auslenkung des Betätigungsglieds (1) eines kapazitiven Mehrwege-Kraftsensorbausteins mit einem aus seiner Neutralstellung in zumindest zwei Betätigungsrichtungen verstellbaren Betätigungsglied (1), das sich bei Fortfall einer Betätigungskraft wieder in seine Neutralstellung zurückverlagert, und mit dem eine zentrale Kondensatorplatte (2) verbunden ist, die sich in der Ruhelage des Betätigungsglieds (1) im Abstand zu zumindest einer ersten und einer zweiten ortsfesten Kondensatorplatte (3, 4) befindet, und durch Verstellung des Betätigungsglieds (1) auf zumindest eine erste ortsfeste Kondensatorplatte (3) zu und von zumindest einer zweiten ortsfesten Kondensatorplatte (4) weg verlagert wird, und wobei zur Erzeugung eines ersten, die Auslenkung des Betätigungsglieds (1) repräsentierenden Sensorwertes zumindest ein durch die zentrale Kondensatorplatte (2) mit zumindest einer ersten ortsfesten Kondensatorplatte (3) gebildeter Messkondensator verwendet wird, **dadurch gekennzeichnet,**
**dass** die erste ortsfeste Kondensatorplatte (3) auf einem Massepotential gehalten wird,
**dass** in einem fortlaufend angewendeten Integrationsverfahren in mehreren aufeinander folgenden Zyklen jeweils:
- die zentrale Kondensatorplatte (2) sowie zumindest die zweite ortsfeste Kondensatorplatte (4) mit einem von dem Massepotential verschiedenen Spannungspotential verbunden und dann von diesem wieder getrennt werden,
- eine auf der zentralen Kondensatorplatte (2) gespeicherte Ladungsmenge auf einen Integrationskondensator mit einem bekannten Kapazitätswert übertragen wird,
**dass** nach einer vorgegebenen Anzahl von Zyklen die dann an dem Integrationskondensator anliegende Spannung mittels eines A/D-Wandlers gemessen und zu dem ersten Sensorwert verarbeitet wird,
und **dass** zur Erzeugung eines zweiten, die Auslenkung des Betätigungsglieds (1) repräsentierenden Sensorwertes ein durch die zentrale Kondensatorplatte (2) mit der zweiten ortsfesten Kondensatorplatte (3) gebildeter Messkondensator verwendet wird.

2. Verfahren nach Anspruch 1, **dadurch gekennzeichnet, dass** sich die zentrale Kondensatorplatte (2) in der Ruhelage des Betätigungsglieds (1) im gleichen Abstand zu der ersten und der zweiten ortsfesten Kondensatorplatte (3, 4) befindet, und durch Verstellung des Betätigungsglieds (1) im gleichen Maße auf die erste ortsfeste Kondensatorplatte (3) zu und von der zweiten ortsfesten Kondensatorplatte (4) weg verlagert wird.

3. Verwendung eines Verfahrens nach einem der Ansprüche 1 oder 2 zur Bestimmung der Auslenkung des Betätigungsglieds (1) eines kapazitiven Mehrwege-Kraftsensorbausteins mit einem aus seiner Neutralstellung in zwei Betätigungsrichtungen entlang einer Achse verstellbaren Betätigungsglied (1).

4. Verwendung eines Verfahrens nach einem der Ansprüche 1 oder 2 zur Bestimmung der Auslenkung des Betätigungsglieds (1) eines kapazitiven Mehrwege-Kraftsensorbausteins mit einem aus seiner Neutralstellung in vier Betätigungsrichtungen um zwei zueinander senkrechte Achsen verstellbaren Betätigungsglied (1).

## Claims

1. Method for determining the deflection of the actuator(1) of a capacitive multipath force sensor module having an actuator(1) which can be displaced from its neutral position in at least two actuating directions, which is displaced back into its neutral position again when an actuating force ceases, and to which a central capacitor plate (2) is connected which, in the rest position of the actuator(1), is located at a distance from at least one first and one second stationary capacitor plate (3, 4) and is displaced by displacement of the actuator(1) towards at least one first stationary capacitor plate (3) and away from at least one second stationary capacitor plate (4), and at least one measuring capacitor formed by the central capacitor plate (2) with at least one first stationary capacitor plate (3) being used to generate a first sensor value representing the deflection of the actuator(1), **characterized**
**in that** the first stationary capacitor plate (3) is held at an earth potential,
**in that**, in a continuously applied integration method in a plurality of successive cycles, in each case:
- the central capacitor plate (2) and at least the second stationary capacitor plate (4) are connected to a voltage potential which is different from the ground potential and then disconnected from it again,
- a quantity of charge stored on the central capacitor plate (2) is transferred to an integration capacitor with a known capacitance value,
and **in that**, after a predetermined number of cycles, the voltage then present on the integration capacitor is measured by means of an A/D converter and processed into the first sensor value,
and **in that** a measuring capacitor formed by the central capacitor plate (2) with the second fixed capacitor plate (3) is used to generate a second sensor value representing the deflection of the actuating element (1).

2. Method according to claim 1, **characterized in that** the central capacitor plate (2) is located in the rest position of the actuator(1) at the same distance from the first and the second stationary capacitor plates (3, 4), and is displaced to the same extent towards the first stationary capacitor plate (3) and away from the second stationary capacitor plate (4) by adjustment of the actuator(1).

3. Use of a method according to one of claims 1 or 2 for determining the deflection of the actuator(1) of a capacitive multipath force sensor module having an actuator(1) which can be displaced from its neutral position in two actuating directions along an axis.

4. Use of a method according to one of claims 1 or 2 for determining the deflection of the actuator(1) of a capacitive multipath force sensor module with an actuator(1) which can be displaced from its neutral position in four actuating directions about two mutually perpendicular axes.

## Revendications

1. Procédé pour déterminer la déviation de l'élélement d'actionnement (1) d'un composant de capteur de force capacitif à plusieurs voies avec un élélement d'actionnement (1) réglable à partir de sa position neutre dans au moins deux directions d'actionnement, qui se déplace à nouveau dans sa position neutre en cas de disparition d'une force d'actionnement, et auquel est reliée une plaque de condensateur centrale (2) qui, dans la position de repos de l'élélement d'actionnement (1), se trouve à distance d'au moins une première et une deuxième plaque de condensateur fixe (3, 4) et est déplacé par déplacement de l'élélement d'actionnement (1) vers au moins une première plaque de condensateur fixe (3) et à l'écart d'au moins une deuxième plaque de condensateur fixe (4), et dans lequel, pour générer une première valeur de capteur représentant la déviation de l'élélement d'actionnement (1), on utilise au moins un condensateur de mesure formé par la plaque de condensateur centrale (2) avec au moins une première plaque de condensateur fixe (3), **caractérisé en ce que** la première plaque de condensateur fixe (3) est maintenue à un potentiel de masse,
**en ce que** dans un procédé d'intégration appliqué en continu, dans plusieurs cycles successifs, respectivement :
- la plaque centrale de condensateur (2) ainsi qu'au moins la deuxième plaque de condensateur (4) sont connecté à un potentiel différent du potentiel de masse et sont ensuite à nouveau séparées de celui-ci,
- une quantité de charge accumulée sur la plaque de condensateur centrale (2) est transférée à un condensateur d'intégration ayant une valeur de capacité connue,
et **en ce qu'**après un nombre prédéterminé de cycles, la tension alors présente au condensateur d'intégration est mesurée au moyen d'un convertisseur A/N et traitée pour obtenir la première valeur de capteur,
et **en ce que**, pour générer une deuxième valeur de capteur représentant la déviation de l'élélement d'actionnement (1), on utilise un condensateur de mesure formé par la plaque de condensateur centrale (2) avec la deuxième plaque de condensateur fixe (3).

2. Procédé selon la revendication 1, **caractérisé en ce que** la plaque centrale de condensateur (2) se trouve, dans la position de repos de l'élélement d'actionnement (1), à la même distance de la première et de la deuxième plaques fixes de condensateur (3, 4), et est déplacée par le réglage de l'élélement d'actionnement (1) dans la même mesure vers la première plaque fixe de condensateur (3) et à l'écart de la deuxième plaque fixe de condensateur (4).

3. Utilisation d'un procédé selon l'une des revendications 1 ou 2 pour déterminer la déviation de l'élélement d'actionnement (1) d'un composant de capteur de force capacitif à voies multiples comportant un élélement d'actionnement (1) réglable le long d'un axe à partir de sa position neutre dans deux directions d'actionnement.

4. Utilisation d'un procédé selon l'une des revendications 1 ou 2 pour déterminer la déviation de l'élélement d'actionnement (1) d'un composant de capteur de force capacitif à voies multiples comportant un élélement d'actionnement (1) réglable à partir de sa position neutre dans quatre directions d'actionnement autour de deux axes perpendiculaires entre eux.
